(19) **Europäisches Patentamt European Patent Office Office européen des brevets**

(11) **EP 4 631 777 A1**

(12) **EUROPEAN PATENT APPLICATION**
published in accordance with Art. 153(4) EPC

(43) Date of publication:
**15.10.2025 Bulletin 2025/42**

(51) International Patent Classification (IPC):
**B60L 58/12** (2019.01)  **B60L 58/16** (2019.01)
**H04W 4/48** (2018.01)  **G06F 18/27** (2023.01)

(21) Application number: **23907313.3**

(52) Cooperative Patent Classification (CPC):
**B60L 58/12; B60L 58/16; G06F 18/27; H04W 4/48**

(22) Date of filing: **25.09.2023**

(86) International application number:
**PCT/KR2023/014675**

(87) International publication number:
**WO 2024/136027 (27.06.2024 Gazette 2024/26)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **23.12.2022  KR 20220183511**
**29.08.2023  KR 20230114024**

(71) Applicant: **LG Energy Solution, Ltd.**
**Seoul 07335 (KR)**

(72) Inventors:
• **EOM, Jin Uk**
  **Daejeon 34122 (KR)**
• **YOO, Ji Won**
  **Daejeon 34122 (KR)**
• **CHOI, Yo Hwan**
  **Daejeon 34122 (KR)**
• **LEE, Hyun Jun**
  **Daejeon 34122 (KR)**

(74) Representative: **Plasseraud IP**
**104 Rue de Richelieu**
**CS92104**
**75080 Paris Cedex 02 (FR)**

(54) **SERVER AND METHOD BY WHICH SAME SERVER ESTIMATES DISTANCE TO EMPTY**

(57)  A server according to one embodiment disclosed herein includes a communication unit configured to receive vehicle data including a current state of charge (SOC) of a battery, an end SOC that is an end point in calculating a distance to empty, a state of health (SOH) of the battery, and travel data of a target vehicle from the target vehicle, and a controller configured to classify valid data including information about the target vehicle traveling a preset distance or more from the travel data, calculate an average fuel efficiency of the target vehicle based on the valid data, and calculate a distance to empty of the target vehicle based on the current SOC, the end SOC, the SOH, and the average fuel efficiency.

FIG.1

**Description**

**[TECHNICAL FIELD]**

CROSS-REFERENCE TO RELATED APPLICATION

This application claims priority to and the benefit of Korean Patent Applications No. 10-2022-0183511 filed in the Korean Intellectual Property Office on December 23, 2022, and No. 10-2023-0114024 filed in the Korean Intellectual Property Office on August 29, 2023, respectively, the entire contents of which are incorporated herein by reference.

TECHNICAL FIELD

Embodiments disclosed herein relate to a server and a method of estimating a distance to empty thereof.

**[BACKGROUND ART]**

Currently commercialized batteries include a nickel cadmium battery, a nickel hydride battery, a nickel zinc battery, a lithium-ion battery, and the like, and among them, since the lithium-ion battery has advantages in that little memory effect occurs compared to the nickel-based battery and thus charge/discharge may be freely performed, a self-discharge rate is very low, and an energy density is high, the lithium-ion battery is attracting attention. The lithium-ion battery is a secondary battery that includes a positive electrode, a negative electrode, an electrolyte, and a separator and may be charged and discharged according to the movement of lithium ions through the electrolyte between the positive electrode and the negative electrode.

Travel distances of electric vehicles using such a secondary battery as a power source are greatly affected by a user's driving habit, a driving environment, and an outside air temperature. However, general methods of predicting a distance to empty of a vehicle predict a distance to empty from a current state of charge (SOC) of the secondary battery up to a point at which the secondary battery is fully discharged and may not reflect the user's driving environment, the driving environment, and the outside air temperature.

[DISCLOSURE]

[TECHNICAL PROBLEM]

Embodiments disclosed therein are directed to providing a server configured to predict a distance to empty of a vehicle by reflecting a driving environment factor and a user's driving habit, and a method of estimating a distance to empty thereof.

The embodiments disclosed therein are also directed to providing a server configured to predict a distance to empty corresponding to a set state of charge (SOC) section set by a user or a SOC section set based on past charge patterns, and a method of estimating a distance to empty thereof.

The embodiments disclosed therein are also directed to providing a server configured to predict a distance to empty by applying a model with high accuracy in estimating a distance to empty based on information about the presence or absence of a current SOC and an outside air temperature, and a method of estimating a distance to empty thereof.

The objects of the embodiments disclosed herein are not limited to the above-described objects, and other objects that are not mentioned will be able to be clearly understood by those skilled in the art from the following description.

[TECHNICAL SOLUTION]

A server according to one embodiment disclosed herein includes a communication unit configured to receive vehicle data including a current state of charge (SOC) of a battery, an end SOC that is an end point in calculating a distance to empty, a state of health (SOH) of the battery, and travel data of a target vehicle from the target vehicle, and a controller configured to classify valid data including information about the target vehicle traveling a preset distance or more from the travel data, calculate an average fuel efficiency of the target vehicle based on the valid data, and calculate a distance to empty of the target vehicle based on the current SOC, the end SOC, the SOH, and the average fuel efficiency.

According to one embodiment, the average fuel efficiency may include latest fuel efficiency calculated by dividing a distance to empty for previous N days of the target vehicle by power consumption for N days and fuel efficiency of a previous month calculated by dividing a distance to empty of a previous month by power consumption used in the previous month.

According to one embodiment, the controller may set the N to a value that allows a mean absolute percentage error (MAPE) of the distance to empty to have the smallest value in a preset range, and calculate the latest fuel efficiency using a sliding window.

According to one embodiment, the controller may calculate the distance to empty based on the SOH, a capacity of the battery, the average fuel efficiency, and a difference between the current SOC and the end SOC.

According to one embodiment, the controller may calculate the distance to empty based on a result of linear regression of a travel distance and a depth of discharge (DoD) of the target vehicle included in the valid data.

According to one embodiment, the vehicle data may further include outside air temperature information of the vehicle, and the controller may calculate the distance to empty based on the SOH, a capacity of the battery, the average fuel efficiency, the outside air temperature information, and a difference between the current SOC and the end SOC.

According to one embodiment, the controller may calculate the distance to empty based on a result of linear regression of a travel distance and a DoD of the target vehicle included in the valid data, and the outside air temperature information.

According to one embodiment, the end SOC may be a charge-required SOC set by a user of the target vehicle.

According to one embodiment, the controller may calculate the distance to empty by different methods when a difference between the current SOC and the end SOC is larger than or equal to a threshold or when the difference between the current SOC and the end SOC is smaller than the threshold.

According to one embodiment, the controller may calculate the distance to empty by different methods depending on whether the vehicle data includes outside air temperature information.

According to one embodiment, the controller may calculate the distance to empty of the target vehicle when the end SOC is smaller than the current SOC.

A method of estimating a distance to empty according to one embodiment disclosed herein includes an operation of receiving vehicle data including a current state of charge (SOC) of a battery, an end SOC that is an end point in calculating a distance to empty, a state of health (SOH) of the battery, and travel data of a target vehicle from the target vehicle, an operation of classifying valid data including information about the target vehicle traveling a preset distance or more from the travel data and calculating an average fuel efficiency of the target vehicle based on the valid data, and an operation of calculating a distance to empty of the target vehicle based on the current SOC, the end SOC, the SOH, and the average fuel efficiency.

According to one embodiment, the method may further include, after the operation of receiving the vehicle data, an operation of determining whether the end SOC is smaller than the current SOC.

According to one embodiment, the method may further includes, after the operation of determining whether the end SOC is smaller than the current SOC, an operation of determining whether the vehicle data includes outside air temperature information, and an operation of determining whether a difference between the current SOC and the end SOC is larger than or equal to a threshold.

According to one embodiment, the operation of calculating the distance to empty may be an operation of calculating the distance to empty of the target vehicle by different methods depending on each of whether the vehicle data includes the outside air temperature information or whether the difference between the current SOC and the end SOC is larger than or equal to a threshold.

According to one embodiment, the average fuel efficiency may include latest fuel efficiency calculated by dividing a distance to empty for previous N days of the target vehicle by power consumption for N days and fuel efficiency of a previous month calculated by dividing a distance to empty of a previous month by power consumption used in the previous month, and the operation of calculating the average fuel efficiency may be an operation of setting the N to a value with the smallest mean absolute percentage error (MAPE) value of the distance to empty in a preset range, and calculating the latest fuel efficiency using a sliding window.

According to one embodiment, the operation of calculating the distance to empty may be an operation of calculating the distance to empty based on the SOH, a capacity of the battery, the average fuel efficiency, and a difference between the current SOC and the end SOC.

Detailed matters of other embodiments are included in a detailed description and accompanying drawings.

**[ADVANTAGEOUS EFFECTS]**

According to the server and the method of estimating the distance to empty thereof according to the embodiments disclosed herein, it is possible to predict the distance to empty by reflecting the driving environment factor and the user's driving habit.

According to the server and the method of estimating the distance to empty thereof according to the embodiments disclosed herein, it is possible to predict the distance to empty corresponding to the SOC section set by the user or the SOC section set based on the past charge patterns.

According to the server and the method of estimating the distance to empty thereof according to the embodiments disclosed herein, it is possible to predict the distance to empty by applying the model with high accuracy in estimating a distance to empty based on the presence or absence of the current SOC and the outside air temperature.

The effects of the server and the method of estimating the distance to empty thereof according to the embodiments disclosed herein are not limited to the above-described effects, and other effects that are not mentioned will be able to be clearly understood by those skilled in the art according to the disclosure of this document.

[DESCRIPTION OF DRAWINGS]

FIG. 1 is a block diagram illustrating a battery system according to one embodiment disclosed herein.
FIG. 2 is a view illustrating a method in which a server according to one embodiment disclosed herein calculates an average fuel efficiency.
FIG. 3 is a view illustrating a method in which the server according to one embodiment disclosed herein extracts parameters applied to a distance to empty calculation model.
FIG. 4 is a graph illustrating a mean absolute percentage error (MAPE) according to a depth of discharge (DOD) of each of the distance to empty calculation model according to one embodiment disclosed herein.
FIG. 5 is a view illustrating an interface provided to a user terminal according to one embodiment disclosed herein.
FIG. 6 is a flowchart illustrating a method of estimating a distance to empty according to one embodiment disclosed herein.
FIG. 7 is a flowchart specifically illustrating an operation of calculating a distance to empty of a target vehicle based on the current state of charge (SOC), the end SOC, the state of health (SOH), and the average fuel efficiency in FIG. 6.

In the description of the drawings, the same or similar reference numerals may be used for the same or similar components.

[MODE FOR INVENTION]

Hereinafter, embodiments of the present invention will be described with reference to the accompanying drawings. However, it should be understood that this is not intended to limit the present invention to specific embodiments and includes various modifications, equivalents, and/or alternatives of the embodiments of the present invention.

It should be understood that the embodiments of this document and the terms used herein are not intended to limit the technical features described herein to specific embodiments and include various modifications, equivalents, or substitutes of the corresponding embodiments. In the description of the drawings, similar reference numerals may be used for similar or related components. The singular form of a noun corresponding to an item may include one item or a plurality of items unless the relevant context clearly dictates otherwise.

In this document, each of phrases such as "A or B," "at least one of A and B," "at least one of A or B," "A, B, or C," "at least one of A, B, and C," and "at least one of A, B, or C" may include any one of the items listed together in the corresponding phrase among these phrases or all possible combinations thereof. The terms such as "first," "second," "first," "second," "A," "B," "(a)," or "(b)" may simply be used to distinguish the corresponding component from another and do not limit the corresponding components in another aspect (e.g., importance or order).

When a certain component (e.g., a first component) is described as being "coupled," "connected," or "joined" to another component (e.g., a second component) with or without the terms "functionally" or "communicatively" or "coupled" or "connected," this means that the certain component may be connected to another component directly (e.g., by wire or wirelessly) or indirectly (e.g., through a third component).

A method according to various embodiments disclosed herein may be provided to be included in a computer program product. The computer program product may be traded between sellers and buyers as commodities. The computer program product may be distributed in the form of a device-readable storage medium (e.g., a compact disc read only memory (CD-ROM)) or distributed (e.g., downloaded or uploaded) through application stores or directly online between two user devices. In the case of the online distribution, at least some of the computer program products may be at least temporarily stored or temporarily generated in a device-readable storage medium such as a memory of a server of a manufacturer, a server of an application store, or a relay server.

According to the embodiments disclosed herein, each component (e.g., a module or a program) of the above-described components may include a single object or a plurality of objects, and some of the plurality of objects may be separately disposed in another component. According to the embodiments disclosed herein, one or more components or operations among the above-described corresponding components may be omitted, or one or more other components or operations may be added. Alternatively or additionally, the plurality of components (e.g., modules or programs) may be integrated into one component. In this case, the integrated component may perform one or more functions of each of the plurality of components identically or similarly to those performed by the corresponding component of the plurality of components before the integration. According to the embodiments disclosed herein, operations performed by modules, programs, or other components may be executed sequentially, in parallel, repeatedly, or heuristically, or one or more of the operations may be executed in a different order or omitted, or one or more other operations may be added.

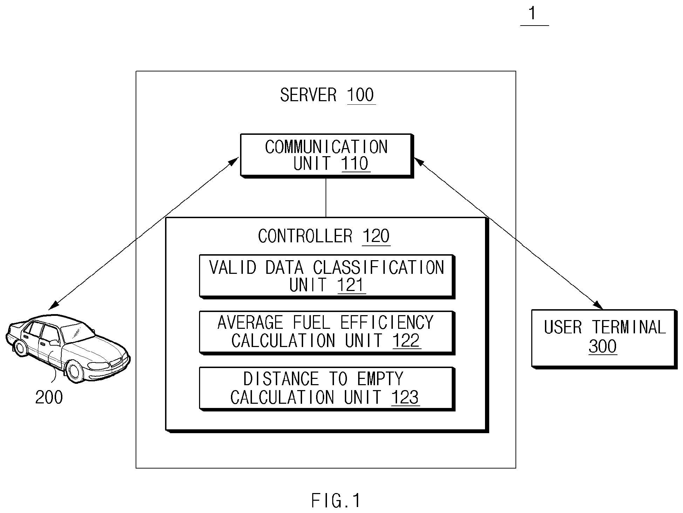

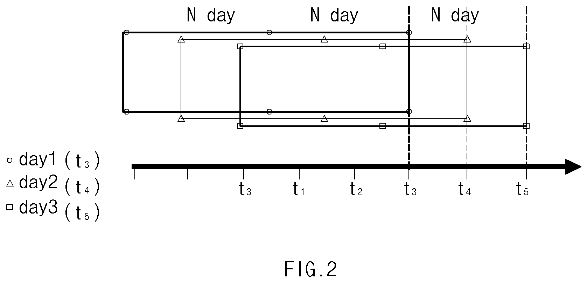

FIG. 1 is a block diagram illustrating a battery system according to one embodiment disclosed herein. FIG. 2 is a view illustrating a method in which a server according to one embodiment disclosed herein calculates an average fuel efficiency.

Referring to FIG. 1, a battery system 1 may include a server 100, a target vehicle 200, and a user terminal 300. The server 100 and the target vehicle 200 and the server 100 and the user terminal 300 may be communicatively connected. The connection between the server 100 and the target vehicle and the connection between the server 100 and the user terminal 300 may be communication connections via a wired and/or wireless network. Here, the wired network may be based on local area network (LAN) communication or power line communication. In addition, the wireless network may be based on a short-range communication network (e.g., Bluetooth, wireless fidelity (Wi-Fi)) or infrared data association (IrDA)) or a telecommunication network (a cellular network, a fourth-generation (4G) network, or a fifth-generation (5G) network).

The server 100 may include a communication unit 110 and a controller 120. The server 100 may estimate a distance to empty of the target vehicle 200 using the communication unit 110 and the controller 120. Here, the distance to empty may be a distance that the target vehicle 200 may travel using power currently stored in a battery without separate charging.

The communication unit 110 may communicate with the target vehicle 200. The communication unit 110 may receive a current state of charge (SOC) of the battery, an end SOC that is an end point in calculating the distance to empty, and a state of health (SOH) of the battery of the target vehicle 200, and authorized fuel efficiency and travel data of the target vehicle from the target vehicle 200.

The communication unit 110 may communicate with the user terminal 300. The communication unit 110 may transmit the distance to empty of the target vehicle 200 to the user terminal 300. In addition, the communication unit 110 may receive average fuel efficiency selection information from the user terminal 300. In other words, the user may select at least one of the authorized fuel efficiency, the latest fuel efficiency, and fuel efficiency of a previous month using the user terminal 300, and the communication unit 110 may receive average fuel efficiency selection information including information about which average fuel efficiency the user has selected.

The controller 120 may include a valid data classification unit 121, an average fuel efficiency calculation unit 122, and a distance to empty calculation unit 123. The controller 120 may calculate the distance to empty of the target vehicle 200 using the valid data classification unit 121, the average fuel efficiency calculation unit 122, and the distance to empty calculation unit 123.

The valid data classification unit 121 may classify valid data from the travel data. According to an embodiment, the valid data classification unit 121 may classify valid data including information about the target vehicle traveling a preset distance or more from the travel data. Here, the preset distance may be set in consideration of a vehicle type of the target vehicle 200.

The average fuel efficiency calculation unit 122 may calculate average fuel efficiency of the target vehicle 200. Here, the average fuel efficiency may include the authorized fuel efficiency, the fuel efficiency of the previous month, and the latest fuel efficiency. In other words, the average fuel efficiency calculation unit 122 may receive the authorized fuel efficiency of the target vehicle 200 from the communication unit and calculate the fuel efficiency of the previous month and the latest fuel efficiency based on the valid data.

The average fuel efficiency calculation unit 122 may calculate the fuel efficiency of the previous month based on valid data of the previous month. In other words, the average fuel efficiency calculation unit 122 may calculate the fuel efficiency of the previous month by dividing a travel distance of the previous month of the target vehicle 200 included in the valid data by power consumption used in the previous month.

Referring to FIG. 2, the average fuel efficiency calculation unit 122 may calculate the latest fuel efficiency. According to an embodiment, the average fuel efficiency calculation unit 122 may calculate the fuel efficiency of the previous month by dividing a travel distance of the target vehicle 200 for previous N days by power consumption used for N days.

First, the average fuel efficiency calculation unit 122 may determine N. Here, N may be a natural number larger than or equal to zero in a preset range. The average fuel efficiency calculation unit 122 may change N in the preset range and compare a distance to empty calculated based on each of the latest fuel efficiencies corresponding to the changed N to a real travel distance. According to an embodiment, the average fuel efficiency calculation unit 122 may calculate the distance to empty by substituting the latest fuel efficiency according to each N into a first model (Base) to be described below and compare the calculated distance to empty to the real travel distance.

According to an embodiment, the average fuel efficiency calculation unit 122 may calculate a mean absolute percentage error (MAPE) based on the calculated distance to empty and the real travel distance. The MAPE may be a method of calculating a relative proportion of an error, which is obtained by dividing a difference between a real value and a predicted value by the real value, in the real value. The smaller the MAPE, the more similar the predicted value and the real value may be.

According to an embodiment, the average fuel efficiency calculation unit 122 may determine that N is a value with the smallest MAPE value of the distance to empty among values in the preset range. For example, the average fuel efficiency calculation unit 122 may calculate the latest fuel efficiency while varying N in a range of 1 to 30, calculate the distance to empty by substituting the latest fuel efficiency into the first model (Base), and calculate the MAPE based on the calculated distance to empty and the real travel distance. In this case, when N is 18, the MAPE of the distance to empty may be the smallest, and the average fuel efficiency calculation unit 122 may determine that N is 18. Hereinafter, description will be made assuming N determined in the same manner.

The average fuel efficiency calculation unit 122 may calculate the latest fuel efficiency using a sliding window. In other words, the average fuel efficiency calculation unit 122 may calculate the latest fuel efficiency based on data corresponding to the previous N days based on the present from the valid data. Therefore, time points included in the previous N days may be changed together in correspondence to a current time point.

For example, when calculating the latest fuel efficiency on day1, the average fuel efficiency calculation unit 122 may extract data corresponding to the previous N days based on day1 from the valid data. In addition, the average fuel efficiency calculation unit 122 may calculate the latest fuel efficiency corresponding to day1 by dividing the distance to empty for N days by the power consumption used for N days based on the calculated data. When calculating the latest fuel efficiency on day2, the average fuel efficiency calculation unit 122 may extract data corresponding to the previous N days based on day2 from the valid data. In addition, the average fuel efficiency calculation unit 122 may calculate the latest fuel efficiency corresponding to day2 by dividing the distance to empty for N days by the power consumption used for N days based on the calculated data. In the case of day3, the latest fuel efficiency corresponding to day3 may also be calculated in the same manner.

Referring back to FIG. 1, the distance to empty calculation unit 123 may calculate the distance to empty of the target vehicle 200. In other words, the distance to empty calculation unit may calculate the distance to empty of the target vehicle 200 based on the current SOC, the end SOC, the SOH, and the average fuel efficiency of the target vehicle 200.

The distance to empty calculation unit 123 may compare the end SOC to the current SOC. The distance to empty calculation unit may calculate the distance to empty of the target vehicle 200 when the end SOC is smaller than the current SOC. The distance to empty calculation unit may not calculate the distance to empty of the target vehicle 200 when the end SOC is larger than or equal to the current SOC. In this case, the distance to empty calculation unit may transmit a notification that the distance to empty may not be calculated to the user using the communication unit 110.

The distance to empty calculation unit may determine whether the vehicle data includes outside air temperature information. The distance to empty calculation unit may calculate the distance to empty of the target vehicle 200 using different distance to empty calculation models depending on whether the vehicle data includes the outside air temperature information.

The distance to empty calculation unit may compare a depth of discharge (DoD) defined as a difference between the current SOC and the end SOC to a threshold. Here, the threshold may be determined experimentally by comparing the distance to empty calculated by the distance to empty calculation unit to a real distance to empty. According to an embodiment, the threshold may be 10%. The distance to empty calculation unit may calculate the distance to empty of the target vehicle 200 using different distance to empty calculation models depending on whether the DoD is smaller than the threshold.

According to an embodiment, the distance to empty calculation unit may determine a distance to empty estimation model depending on whether the vehicle data includes the outside air temperature information and whether the DoD is smaller than the threshold. Here, the distance to empty estimation model may include the first model (Base), a second model (Advanced), a third model (Temp), and a fourth model (Advanced temperature).

Specifically, when the vehicle data does not include the outside air temperature information and the DoD is smaller than the threshold, the distance to empty calculation unit may calculate the distance to empty of the target vehicle 200 using the first model (Base). When the vehicle data does not include the outside air temperature information and the DoD is larger than or equal to the threshold, the distance to empty calculation unit may calculate the distance to empty of the target vehicle 200 using the second model (Advanced). When the vehicle data includes the outside air temperature information and the DoD is smaller than the threshold, the distance to empty calculation unit may calculate the distance to empty of the target vehicle 200 using the third model (Temp). When the vehicle data includes the outside air temperature information and the DoD is larger than or equal to the threshold, the distance to empty calculation unit may calculate the distance to empty of the target vehicle 200 using the fourth model (Advanced temperature).

According to an embodiment, when the vehicle data does not include the outside air temperature information, the distance to empty calculation unit may calculate the distance to empty using the first model (Base) when the DOD is larger than or equal to zero and smaller than the threshold and calculate the distance to empty using the second model (Advanced) when the DOD is larger than or equal to the threshold. In other words, when the current SOC decreases as the target vehicle 200 travels and the difference between the current SOC and the end SOC decreases to the threshold or less, the distance to empty calculation unit may change the applied model from the second model (Advanced) to the first model (Base).

According to an embodiment, when the vehicle data does not include the outside air temperature information, the distance to empty calculation unit may calculate the distance to empty using the first model (Base) when the DOD is larger than or equal to zero and smaller than the threshold and calculate the distance to empty using the second model (Advanced) when the DOD is larger than or equal to the threshold. In other words, when the current SOC decreases as the target vehicle 200 travels and the difference between the current SOC and the end SOC decreases to the threshold or less, the distance to empty calculation unit may change the applied model from the second model (Advanced) to the first model (Base).

According to an embodiment, when the vehicle data includes the outside air temperature information, the distance to empty calculation unit may calculate the distance to empty using the third model (Temp) when the DOD is larger than or equal to zero and smaller than the threshold and calculate the distance to empty using the fourth model (Advanced temperature) when the DOD is larger than or equal to the threshold. In other words, when the current SOC decreases as the target vehicle 200 travels and the difference between the current SOC and the end SOC decreases to the threshold or less, the distance to empty calculation unit may change the applied model from the fourth model (Advanced temperature) to the third model (Temp).

The distance to empty calculation unit may calculate the distance to empty of the target vehicle 200 using the first model (Base). The distance to empty calculation unit may calculate the distance to empty of the target vehicle 200 by inputting an SOH, a capacity of the battery, an average fuel efficiency, and a DoD into the first model (Base). In other words, the distance to empty calculation unit may calculate the distance to empty using Equation 1 below.

[Equation 1]

$$D=(SOH*y*x)*DoD$$

In Equation 1, D denotes the distance to empty, the SOH is the SOH of the battery of the target vehicle 200, y denotes the capacity of the battery of the target vehicle 200, x denotes the average fuel efficiency, and the DoD is the difference between the current SOC and the end SOC of the battery of the target vehicle 200.

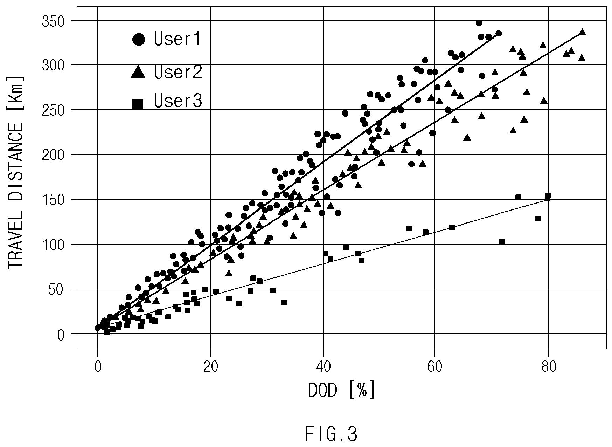

A method in which the distance to empty calculation unit calculates the distance to empty using the second model (Advanced), the third model (Temp), and the fourth model (Advanced temperature) will be described below with reference to FIG. 3.

The distance to empty calculation unit may transmit the calculated distance to empty to the user terminal 300. According to the embodiment, the distance to empty calculation unit may transmit the distance to empty calculated based on fuel efficiency selected from the authorized fuel efficiency, the fuel efficiency of the previous month, and the most recent fuel efficiency to the user terminal 300 or transmit all distances to empty calculated according to each of the authorized fuel efficiency, the fuel efficiency of the previous month, and the most recent fuel efficiency to the user terminal 300.

The target vehicle 200 may be an electric vehicle. In other words, the target vehicle 200 may be an electric vehicle that is the object of the distance to empty calculation. For example, the target vehicle 200 may be an electric vehicle (EV), a hybrid EV (HEV), a plug-in HEV (PHEV), or a fuel cell EV (FCEV).

According to an embodiment, the target vehicle 200 may include one or more battery units. Each of the one or more battery units may be a battery cell, a battery module, a battery pack, or a battery rack.

The target vehicle 200 may transmit vehicle data including current SOCs, end SOCs, and SOHs of the battery units and travel data to the communication unit 110. According to an embodiment, the target vehicle 200 may transmit the end SOC set by the user using the user terminal 300 or the like without transmitting the end SOC to the communication unit 110.

The user terminal 300 may receive the distance to empty from the server 100. In addition, the user terminal 300 may transmit the end SOC set by the user to the server 100.

According to an embodiment, the user terminal 300 may be a mobile device (e.g., a portable phone, a laptop computer, a smart phone, or a smart pad) or a personal computer (PC), but is not limited thereto. For example, the user terminal 300 is not a separate device independent of the target vehicle 200, but may be a device included in the target vehicle 200 and controlled by a driver of the target vehicle 200.

FIG. 3 is a view illustrating a method in which the server according to one embodiment disclosed herein extracts parameters applied to a distance to empty calculation model.

Referring to FIG. 3, the distance to empty calculation unit may calculate the distance to empty of the target vehicle 200 using the second model (Advanced), the third model (Temp), and the fourth model (Advanced temperature).

The distance to empty calculation unit may calculate the distance to empty using the second model (Advanced). In other words, the distance to empty calculation unit may calculate the distance to empty using Equation 2 below.

[Equation 2]

$$D=a*(SOH*y*x)*DoD+b$$

In Equation 2, D denotes the distance to empty, the SOH is the SOH of the battery of the target vehicle 200, y denotes the capacity of the battery of the target vehicle 200, x denotes the average fuel efficiency, the DoD is the difference between the current SOC and the end SOC of the battery of the target vehicle 200, and a and b denote parameters of the second model (Advanced).

First, the distance to empty calculation unit may determine the parameters of the second model (Advanced) and confirm the second model (Advanced). According to the embodiment, in other words, the distance to empty calculation unit may determine the parameters of the second model (Advanced) using linear regression. The distance to empty calculation unit may display each travel distance data for the DoD included in the valid data on a graph. The distance to empty calculation unit may determine a and b by comparing an equation acquired by applying the linear regression to the travel distance data for the DoD to Equation 2. In other words, the distance to empty calculation unit may confirm the second model (Advanced) by applying the linear regression to the valid data.

The distance to empty calculation unit may calculate the distance to empty by inputting the SOH, the capacity of the battery, the average fuel efficiency, and the DoD into the confirmed Equation 2.

The distance to empty calculation unit may calculate the distance to empty using the third model (Temp). In other words, the distance to empty calculation unit may calculate the distance to empty using Equation 3 below.

[Equation 3]

$$D=(SOH*y*x)*(c*T+d)*DoD$$

In Equation 3, D denotes the distance to empty, the SOH is the SOH of the battery of the target vehicle 200, y denotes the capacity of the battery of the target vehicle 200, x denotes the average fuel efficiency, the DoD is the difference between the current SOC and the end SOC of the battery of the target vehicle 200, T denotes the outside air temperature of the target vehicle 200, and c and d denote parameters of the third model (Temp).

First, the distance to empty calculation unit may determine the parameters of the third model (Temp) and confirm the third model (Temp). According to the embodiment, in other words, the distance to empty calculation unit may determine the parameters of the third model (Temp) using the linear regression. The distance to empty calculation unit may display each travel distance data for the DoD included in the valid data on a graph. The distance to empty calculation unit may determine c and d by comparing an equation acquired by applying the linear regression to the travel distance data for the DoD to Equation 3. In other words, the distance to empty calculation unit may confirm the third model (Temp) by applying the linear regression to the valid data.

The distance to empty calculation unit may calculate the distance to empty by inputting the SOH, the capacity of the battery, the average fuel efficiency, and the DoD into the confirmed Equation 3.

The distance to empty calculation unit may calculate the distance to empty using the fourth model (Advanced temperature). In other words, the distance to empty calculation unit may calculate the distance to empty using Equation 4 below.

[Equation 4]

$$D=(SOH*y*x)*(c*T+d)*DoD+e$$

In Equation 4, D denotes the distance to empty, the SOH is the SOH of the battery of the target vehicle 200, y denotes the capacity of the battery of the target vehicle 200, x denotes the average fuel efficiency, the DoD is the difference between the current SOC and the end SOC of the battery of the target vehicle 200, T denotes the outside air temperature of the target vehicle 200, and c, d, and e denote parameters of the fourth model (Advanced temperature).

First, the distance to empty calculation unit may determine the parameters of the fourth model (Advanced temperature) and confirm the fourth model (Advanced temperature). According to the embodiment, in other words, the distance to empty calculation unit may determine the parameters of the fourth model (Advanced temperature) using the linear regression. The distance to empty calculation unit may display each travel distance data for the DoD included in the valid data on a graph. The distance to empty calculation unit may determine c, d, and e by comparing an equation acquired by applying the linear regression to the travel distance data for the DoD to Equation 4. In other words, the distance to empty calculation unit may confirm the fourth model (Advanced temperature) by applying the linear regression to the valid data.

The distance to empty calculation unit may calculate the distance to empty by inputting the SOH, the capacity of the battery, the average fuel efficiency, and the DoD into the confirmed Equation 4.

Models 2 to 4 may be different depending on the user of the target vehicle 200. Since the parameters included in each model are determined based on the valid data corresponding to the user of the target vehicle 200, Models 2 to 4 finally confirmed may be different depending on the user.

For example, when Model 2 is applied to User 1 (User1), User 2 (User2), and User 3 (User3), equations derived by applying the linear regression for each user may be different. In other words, a slope and a y-intercept may be different for each user. Since Model 2 is confirmed based on the equation derived by applying the linear regression, parameter a of Model 2 has a larger size for User 1 (User1) than User 2 (User2) and a larger size for User 2 (User2) than User 3 (User3). Therefore, the server 100 may provide each user with the distance to empty calculated by reflecting a driving habit for each user.

The server 100 can increase the accuracy in calculating the distance to empty by reflecting the driving habits of each user in calculating the distance to empty. In addition, the server 100 can increase the accuracy in estimating the distance to empty by estimating the distance to empty using a more accurate model based on the presence or absence of the outside air temperature and magnitudes of the current SOC and the end SOC. In addition, the server 100 may provide the remaining distance to empty until the user charges the target vehicle 200 by calculating the distance to empty corresponding to an SOC section set by the user. Therefore, the user may intuitively establish a driving plan based on the distance to empty.

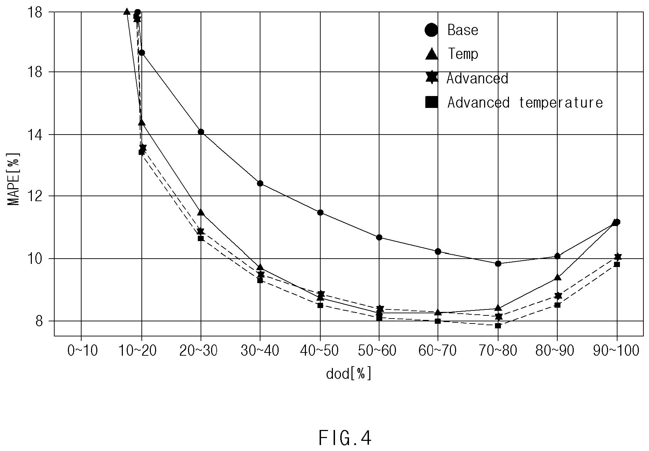

FIG. 4 is a graph illustrating a mean absolute percentage error (MAPE) according to a depth of discharge (DOD) of each of the distance to empty calculation model according to one embodiment disclosed herein.

Referring to FIG. 4, the first model (Base), the second model (Advanced), the third model (Temp), and the fourth model (Advanced temperature) included in the distance to empty calculation model may be different.

When the MAPEs of each model according to DoD are compared, in a section in which the DoD is smaller than 10, the MAPE of the first model (Base) may be smaller than that of the second model (Advanced). In other words, the smaller the MAPE, the higher the accuracy, and thus in the section in which the DoD is smaller than 10, the first model (Base) may have higher accuracy than the second model (Advanced).

In a section in which the DoD is 10 or more, the MAPE of the first model (Base) may be larger than that of the second model (Advanced). In other words, in the section in which the DoD is 10 or more, the second model (Advanced) may have higher accuracy than the first model (Base).

According to an embodiment, the distance to empty calculation unit may calculate the distance to empty by applying the first model (Base) when the DoD is 0 to 10 and applying the second model (Advanced) when the DoD is 10 or more.

In addition, in the section in which the DoD is smaller than 10, the MAPE of the third model (Temp) may be smaller than that of the fourth model (Advanced temperature). In other words, in the section in which the DoD is smaller than 10, the third model (Temp) may have higher accuracy than the fourth model (Advanced temperature).

In the section in which the DoD is 10 or more, the MAPE of the third model (Temp) may be larger than that of the fourth model (Advanced temperature). In other words, in the section in which the DoD is 10 or more, the fourth model (Advanced temperature) may have higher accuracy than the third model (Temp).

According to an embodiment, the distance to empty calculation unit may calculate the distance to empty by applying the third model (Temp) when the DoD is 0 to 10 and applying the fourth model (Advanced temperature) when the DoD is 10 or more.

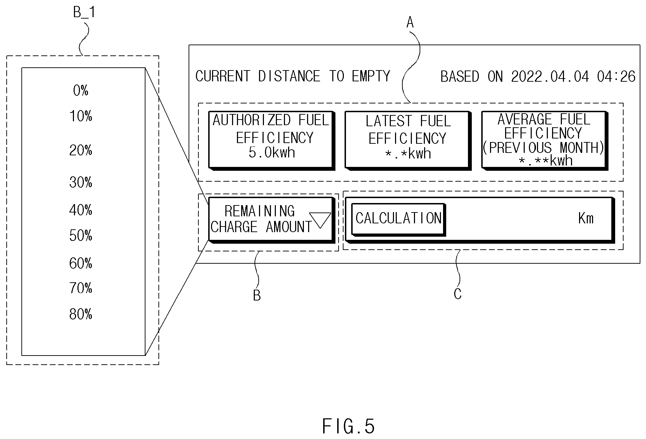

FIG. 5 is a view illustrating an interface provided to a user terminal according to one embodiment disclosed herein.

Referring to FIG. 5, the user terminal 300 may include an interface configured to provide information to the user. The interface may include areas A, B, and C. According to an embodiment, the interface may display authorized fuel efficiency, the latest fuel efficiency, and average fuel efficiency in area A. Therefore, the user may check the authorized fuel efficiency, the latest fuel efficiency, and the average fuel efficiency by checking area A. According to an embodiment, the user may set fuel efficiency to be the basis for calculating the distance to empty among the authorized fuel efficiency, the latest fuel efficiency, and the average fuel efficiency by clicking or touching area A. According to the user's fuel efficiency settings, the server 100 may calculate the distance to empty based on the set fuel efficiency and provide the calculated distance to empty to the user.

The interface may display the remaining charge amount in area B. Here, the remaining charge amount may be a DoD that is a difference between a current SOC and an end SOC. In other words, the interface may display the charge amount of the battery that remains up to the end SOC in area B.

According to an embodiment, when the user clicks or touches area B, area B_1 may be activated. The user may set the end SOC using area B_1. In other words, the user may set an end time point of the distance to empty calculation using area B_1. Therefore, the user may check the distance to empty of the target vehicle 200 from the current SOC to the SOC of the battery set by the user. Therefore, the user may efficiently check the distance to empty of the target vehicle 200 by setting the end SOC in consideration of driving environment factors, a driving plan, a distance to empty, a position of a nearby charging station, or the like and checking a distance to empty calculated up to the set end SOC.

The interface may display the distance to empty calculated in consideration of the average fuel efficiency and the end SOC in area C. According to an embodiment, the user terminal 300 may display the distance to empty received from the server 100 in area C. Therefore, the user may check the distance to empty of the target vehicle 200 by checking area C.

Therefore, the server 100 may predict the distance to empty by reflecting the driving environment factors and the user's driving habit. The server 100 may predict a distance to empty corresponding to a SOC section set by the user or an SOC section set based on past charge patterns. In addition, the server 100 may predict the distance to empty by applying a model with high accuracy in estimating the distance to empty based on the presence or absence of information about the current SOC and the outside air temperature.

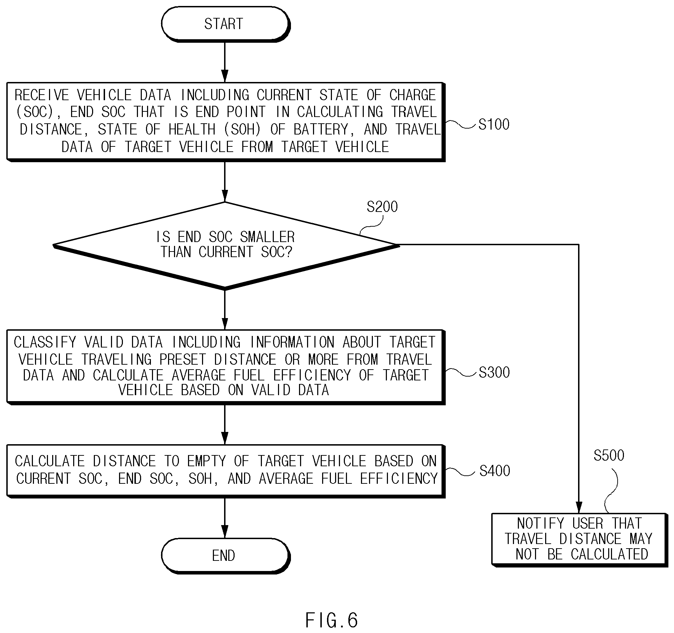

FIG. 6 is a flowchart illustrating a method of estimating a distance to empty according to one embodiment disclosed herein.

The embodiment illustrated in FIG. 6 is only one embodiment, the order of operations according to various embodiments of the present invention may be different from that illustrated in FIG. 6, and some operations illustrated in FIG. 6 may be omitted, the order between the operations may be changed, or the operations may be merged.

Referring to FIG. 6, the method of estimating the distance to empty may include an operation of receiving vehicle data including the current SOC of the battery, the end SOC that is an end point in calculating the distance to empty, the SOH of the battery, and the travel data of the target vehicle 200 from the target vehicle 200 (S100), an operation of determining whether the end SOC is smaller than the current SOC (S200), an operation of classifying the valid data including information about the target vehicle 200 traveling a preset distance or more from the travel data and calculating the average fuel efficiency of the target vehicle 200 based on the valid data (S300), an operation of calculating the distance to empty of the target vehicle 200 based on the current SOC, the end SOC, the SOH, and the average fuel efficiency (S400), and an operation of transmitting the notification that the distance to empty may not be calculated to the user (S500).

Hereinafter, the operations S100 to S500 will be described in detail with reference to FIGS. 1 to 5.

In operation S100, the server 100 may receive the vehicle data including the current SOC of the battery, the end SOC that is the end point in calculating the distance to empty, the SOH of the battery, and the travel data of the target vehicle 200 from the target vehicle 200.

The server 100 may communicate with the target vehicle 200. The server 100 may receive the vehicle data including the current SOC of the battery, the end SOC that is the end point in calculating the distance to empty, and the SOH of the battery of the target vehicle 200, and the authorized fuel efficiency and the travel data of the target vehicle from the target vehicle 200.

In operation S200, the server 100 may determine whether the end SOC is smaller than the current SOC.

The server 100 may perform operation S300 when the end SOC is smaller than the current SOC. The server 100 may perform operation S500 when the end SOC is larger than or equal to the current SOC.

In operation S300, the server 100 may classify the valid data including information about the target vehicle traveling the preset distance or more from the travel data and calculate the average fuel efficiency of the target vehicle 200 based on the valid data.

The server 100 may classify the valid data from the travel data. According to an embodiment, the server 100 may classify the valid data including the information about the target vehicle traveling the preset distance or more from the travel data. Here, the preset distance may be set in consideration of a vehicle type of the target vehicle 200.

The server 100 may calculate the average fuel efficiency of the target vehicle 200 based on the valid data. Here, the average fuel efficiency may include the authorized fuel efficiency, the fuel efficiency of the previous month, and the latest fuel efficiency.

The server 100 may calculate the authorized fuel efficiency based on the vehicle type of the target vehicle 200. In other words, the server 100 may calculate the authorized fuel efficiency based on the vehicle type information of the target vehicle 200 included in the vehicle data.

The server 100 may calculate the fuel efficiency of the previous month based on the valid data of the previous month. In other words, the server 100 may calculate the fuel efficiency of the previous month by dividing the distance to empty of the previous month of the target vehicle 200 included in the valid data by the power consumption used in the previous month.

The server 100 may calculate the latest fuel efficiency. According to an embodiment, the server 100 may calculate the fuel efficiency of the previous month by dividing the travel distance of the target vehicle 200 for previous N days by the power consumption used for N days.

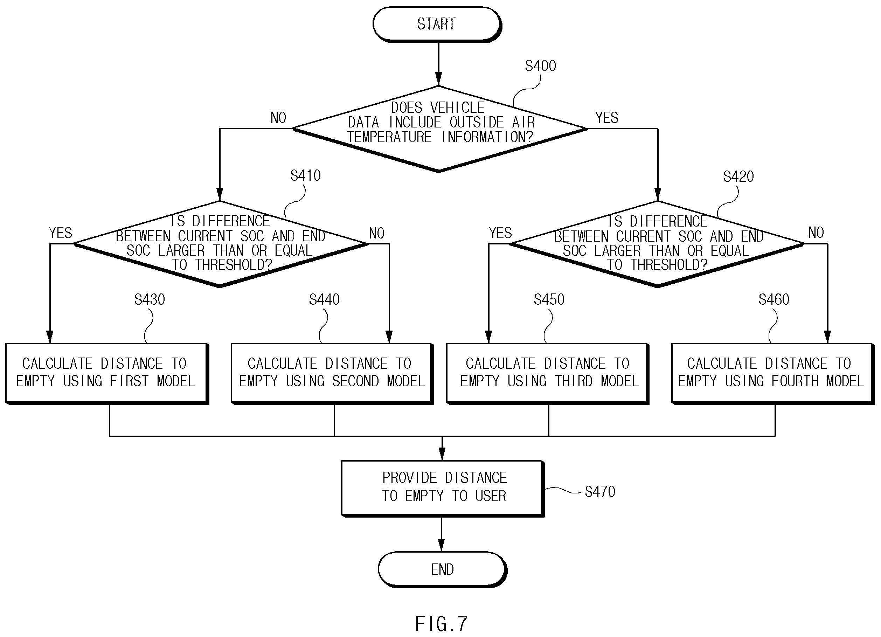

In operation S400, the server 100 may calculate the distance to empty of the target vehicle 200 based on the current SOC, the end SOC, the SOH, and the average fuel efficiency. Operation S400 will be specifically described below with reference to FIG. 7.

In operation S500, the server 100 may transmit the notification that the distance to empty may not be calculated to the user. The server 100 may transmit the notification that the distance to empty may not be calculated to the user by transmitting the notification that the distance to empty may not be calculated to the user terminal 300.

FIG. 7 is a flowchart specifically illustrating an operation of calculating a distance to empty of a target vehicle based on the current SOC, the end SOC, the SOH, and the average fuel efficiency in FIG. 6.

Referring to FIG. 7, the operation of calculating the distance to empty of the target vehicle 200 based on the current SOC, the end SOC, the SOH, and the average fuel efficiency may include an operation of determining whether the vehicle data includes the outside air temperature information (S410), an operation of determining whether the difference between the current SOC and the end SOC is larger than or equal to the threshold (S420), an operation of determining whether the difference between the current SOC and the end SOC is larger than or equal to the threshold (S430), an operation of calculating the distance to empty using the first model (Base) (S440), an operation of calculating the distance to empty using the second model (Advanced) (S450), an operation of calculating the distance to empty using the third model (Temp) (S460), an operation of calculating the distance to empty using the fourth model (Advanced temperature) (S470), and an operation of providing the distance to empty to the user (S480).

In operation S410, the server 100 may determine whether the vehicle data includes the outside air temperature information. The server 100 may determine whether the vehicle data includes the outside air temperature information. The server 100 may calculate the distance to empty of the target vehicle 200 using different distance to empty calculation models depending on whether the vehicle data includes the outside air temperature information.

When the vehicle data does not include the outside air temperature information, operation S420 may be performed. When the vehicle data includes the outside air temperature information, operation S430 may be performed.

In operation S420, the server 100 may determine whether the difference between the current SOC and the end SOC is larger than or equal to the threshold.

The server 100 may compare the DoD defined as the difference between the current SOC and the end SOC to the threshold. Here, the threshold may be determined experimentally by comparing the distance to empty calculated by the server 100 to the real travel distance.

When the DoD is smaller than the threshold, operation S440 may be performed. When the DoD is larger than or equal to the threshold, operation S450 may be performed.

In operation S430, the server 100 may determine whether the difference between the current SOC and the end SOC is larger than or equal to the threshold. Operation S430 may be substantially the same operation as operation S420. When the DoD is smaller than the threshold, operation S460 may be performed. When the DoD is larger than or equal to the threshold, operation S470 may be performed.

In operation S440, the server 100 may calculate the distance to empty using the first model (Base).

The server 100 may calculate the distance to empty of the target vehicle 200 using the first model (Base). The server 100 may calculate the distance to empty of the target vehicle 200 by inputting the SOH, the capacity of the battery, the average fuel efficiency, and the DoD into the first model (Base). In other words, the server 100 may calculate the distance to empty using Equation 1.

In operation S450, the server 100 may calculate the distance to empty using the second model (Advanced).

The server 100 may calculate the distance to empty using the second model (Advanced). In other words, the server 100 may calculate the distance to empty using Equation 2.

First, the server 100 may determine the parameters of the second model (Advanced) and confirm the second model (Advanced). According to an embodiment, in other words, the server 100 may determine the parameters of the second model (Advanced) using the linear regression. The server 100 may display each of the distance to empty data for the DoD included in the valid data on a graph. The server 100 may determine a and b by comparing the equation acquired by applying the linear regression to the travel distance data for the DoD to Equation 2. In other words, the server 100 may confirm the second model (Advanced) by applying the linear regression to the valid data.

The server 100 may calculate the distance to empty by inputting the SOH, the capacity of the battery, the average fuel efficiency, and the DoD into the confirmed Equation 2.

In operation S460, the server 100 may calculate the distance to empty using the third model (Temp).

The server 100 may calculate the distance to empty using the third model (Temp). In other words, the server 100 may calculate the distance to empty using Equation 3.

First, the server 100 may determine the parameters of the third model (Temp) and confirm the third model (Temp). According to an embodiment, in other words, the server 100 may determine the parameters of the third model (Temp) using the linear regression. The server 100 may display each of the distance to empty data for the DoD included in the valid data on a graph. The server 100 may determine c and d by comparing the equation acquired by applying the linear regression to the travel distance data for the DoD to Equation 3. In other words, the server 100 may confirm the third model (Temp) by applying the linear regression to the valid data.

The server 100 may calculate the distance to empty by inputting the SOH, the capacity of the battery, the average fuel efficiency, and the DoD into the confirmed Equation 3.

In operation S470, the server 100 may calculate the distance to empty using the fourth model (Advanced temperature).

The server 100 may calculate the distance to empty using the fourth model (Advanced temperature). In other words, the server 100 may calculate the distance to empty using Equation 4.

First, the server 100 may determine the parameters of the fourth model (Advanced temperature) and confirm the fourth model (Advanced temperature). According to an embodiment, in other words, the server 100 may determine the parameters of the fourth model (Advanced temperature) using the linear regression. The server 100 may display each of the distance to empty data for the DoD included in the valid data on a graph. The server 100 may determine c, d, and e by comparing the equation acquired by applying the linear regression to the travel distance data for the DoD to Equation 4. In other words, the server 100 may confirm the fourth model (Advanced temperature) by applying the linear regression to the valid data.

The server 100 may calculate the distance to empty by inputting the SOH, the capacity of the battery, the average fuel efficiency, and the DoD into the confirmed Equation 4.

In operation S480, the server 100 may provide the distance to empty to the user. The server 100 may transmit the calculated distance to empty to the user terminal 300. In other words, the server 100 may provide the distance to empty to the user through the user terminal 300.

The above description is merely the exemplary description of the technical spirit disclosed herein, and those skilled in the art to which embodiments disclosed herein pertain will be able to variously modify and change the embodiments without departing from the essential characteristics of the embodiments disclosed herein.

Therefore, the embodiments disclosed herein are not intended to limit the technical spirit disclosed herein, but for describing it, and the scope of the technical spirit disclosed herein is not limited by these embodiments. The scope of the technical spirit disclosed herein should be construed by the appended claims, and all technical spirits within the equivalent range should be construed as being included in the scope of this document.

**Claims**

1.   A server comprising:

a communication unit configured to receive vehicle data including a current state of charge (SOC) of a battery, an end SOC that is an end point in calculating a distance to empty, a state of health (SOH) of the battery, and travel data of a target vehicle from the target vehicle; and
a controller configured to classify valid data including information about the target vehicle traveling a preset distance or more from the travel data, calculate an average fuel efficiency of the target vehicle based on the valid data, and
calculate a distance to empty of the target vehicle based on the current SOC, the end SOC, the SOH, and the average fuel efficiency.

2.   The server according to claim 1, wherein the average fuel efficiency includes latest fuel efficiency calculated by dividing a distance to empty for previous N days of the target vehicle by power consumption for N days and fuel efficiency of a previous month calculated by dividing a distance to empty of a previous month by power consumption used in the previous month.

3.   The server according to claim 2, wherein the controller is configured to:

set the N to a value that allows a mean absolute percentage error (MAPE) of the distance to empty to have the smallest value in a preset range; and
calculate the latest fuel efficiency using a sliding window.

4.   The server according to claim 1, wherein the controller calculates the distance to empty based on the SOH, a capacity of the battery, the average fuel efficiency, and a difference between the current SOC and the end SOC.

5.   The server according to claim 4, wherein the controller calculates the distance to empty based on a result of linear regression of a travel distance and a depth of discharge (DoD) of the target vehicle included in the valid data.

6.   The server according to claim 1, wherein the vehicle data further includes outside air temperature information of the vehicle, and
the controller calculates the distance to empty based on the SOH, a capacity of the battery, the average fuel efficiency, the outside air temperature information, and a difference between the current SOC and the end SOC.

7. The server according to claim 6, wherein the controller calculates the distance to empty based on a result of linear regression of a travel distance and a DoD of the target vehicle included in the valid data, and the outside air temperature information.

8. The server according to claim 1, wherein the end SOC is a charge-required SOC set by a user of the target vehicle.

9. The server according to claim 1, wherein the controller calculates the distance to empty by different methods when a difference between the current SOC and the end SOC is larger than or equal to a threshold or when the difference between the current SOC and the end SOC is smaller than the threshold.

10. The server according to claim 9, wherein the controller calculates the distance to empty by different methods depending on whether the vehicle data includes outside air temperature information.

11. The server according to claim 1, wherein the controller calculates the distance to empty of the target vehicle when the end SOC is smaller than the current SOC.

12. A method of estimating a distance to empty, comprising:

    an operation of receiving vehicle data including a current state of charge (SOC) of a battery, an end SOC that is an end point in calculating a distance to empty, a state of health (SOH) of the battery, and travel data of a target vehicle from the target vehicle;
    an operation of classifying valid data including information about the target vehicle traveling a preset distance or more from the travel data and calculating average fuel efficiency of the target vehicle based on the valid data; and
    an operation of calculating a distance to empty of the target vehicle based on the current SOC, the end SOC, the SOH, and the average fuel efficiency.

13. The method according to claim 12, further comprising, after the operation of receiving the vehicle data, an operation of determining whether the end SOC is smaller than the current SOC.

14. The method according to claim 13, further comprising:

    after the operation of determining whether the end SOC is smaller than the current SOC,
    an operation of determining whether the vehicle data includes outside air temperature information; and
    an operation of determining whether a difference between the current SOC and the end SOC is larger than or equal to a threshold.

15. The method according to claim 14, wherein the operation of calculating the distance to empty is an operation of calculating the distance to empty of the target vehicle by different methods depending on each of whether the vehicle data includes the outside air temperature information or whether the difference between the current SOC and the end SOC is larger than or equal to a threshold.

16. The method according to claim 12, wherein the average fuel efficiency includes latest fuel efficiency calculated by dividing a distance to empty for previous N days of the target vehicle by power consumption for N days and fuel efficiency of a previous month calculated by dividing a distance to empty of a previous month by power consumption used in the previous month, and

    the operation of calculating the average fuel efficiency is an operation of setting the N to a value that allows a mean absolute percentage error (MAPE) of the distance to empty to have the smallest value in a preset range, and calculating the latest fuel efficiency using a sliding window.

17. The method according to claim 12, wherein the operation of calculating the distance to empty is an operation of calculating the distance to empty based on the SOH, a capacity of the battery, the average fuel efficiency, and a difference between the current SOC and the end SOC.

1

SERVER 100

COMMUNICATION
UNIT 110

CONTROLLER 120

VALID DATA CLASSIFICATION
UNIT 121

AVERAGE FUEL EFFICIENCY
CALCULATION UNIT 122

DISTANCE TO EMPTY
CALCULATION UNIT 123

200

USER TERMINAL
300

FIG.1

N day　　　　N day　　　　N day

∘ day1 ( t₃ )
△ day2 ( t₄ )
□ day3 ( t₅ )

t₃　　t₁　　t₂　　t₃　　t₄　　t₅

FIG.2

FIG.3

FIG.4

B_1

| | |
|---|---|
| 0% | |
| 10% | |
| 20% | |
| 30% | |
| 40% | |
| 50% | |
| 60% | |
| 70% | |
| 80% | |

A

CURRENT DISTANCE TO EMPTY          BASED ON 2022.04.04 04:26

AUTHORIZED FUEL
EFFICIENCY
5.0kwh

LATEST FUEL
EFFICIENCY
*.*kwh

AVERAGE FUEL
EFFICIENCY
(PREVIOUS MONTH)
*.**kwh

REMAINING
CHARGE AMOUNT ▽

CALCULATION          Km

B                    C

FIG.5

START

RECEIVE VEHICLE DATA INCLUDING CURRENT STATE OF CHARGE
(SOC), END SOC THAT IS END POINT IN CALCULATING TRAVEL
DISTANCE, STATE OF HEALTH (SOH) OF BATTERY, AND TRAVEL
DATA OF TARGET VEHICLE FROM TARGET VEHICLE ⟿S100

S200

IS END SOC SMALLER
THAN CURRENT SOC?

CLASSIFY VALID DATA INCLUDING INFORMATION ABOUT TARGET
VEHICLE TRAVELING PRESET DISTANCE OR MORE FROM TRAVEL
DATA AND CALCULATE AVERAGE FUEL EFFICIENCY OF TARGET
VEHICLE BASED ON VALID DATA ⟿S300

CALCULATE DISTANCE TO EMPTY OF TARGET VEHICLE BASED ON
CURRENT SOC, END SOC, SOH, AND AVERAGE FUEL EFFICIENCY ⟿S400

S500

NOTIFY USER THAT
TRAVEL DISTANCE MAY
NOT BE CALCULATED

END

FIG.6

FIG.7

## INTERNATIONAL SEARCH REPORT

| | International application No. |
|---|---|
| | **PCT/KR2023/014675** |

| A. | CLASSIFICATION OF SUBJECT MATTER |
|---|---|
| | **B60L 58/12**(2019.01)i; **B60L 58/16**(2019.01)i; **H04W 4/48**(2018.01)i; **G06F 18/27**(2023.01)i |

According to International Patent Classification (IPC) or to both national classification and IPC

| B. | FIELDS SEARCHED |
|---|---|

Minimum documentation searched (classification system followed by classification symbols)

B60L 58/12(2019.01); B60K 6/22(2007.10); B60L 11/18(2006.01); B60L 3/00(2006.01); B60L 50/15(2019.01); B60L 53/30(2019.01); B60L 58/10(2019.01); B60W 20/00(2006.01); G06F 17/00(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 주행(driving), 전비(electric cost), 차량(vehicle), SOC(State Of Charge), SOH(State Of Health)

| C. | DOCUMENTS CONSIDERED TO BE RELEVANT |
|---|---|

| Category* | Citation of document, with indication, where appropriate, of the relevant passages | Relevant to claim No. |
|---|---|---|
| A | KR 10-2021-0111128 A (HYUNDAI MOTOR COMPANY et al.) 10 September 2021 (2021-09-10) See paragraphs [0038]-[0044]; and figures 1-2. | 1-17 |
| A | JP 2020-029177 A (MAZDA MOTOR CORP.) 27 February 2020 (2020-02-27) See paragraphs [0012]-[0026]; claims 1-3; and figures 1-5. | 1-17 |
| A | JP 2015-116006 A (MITSUBISHI MOTORS CORP.) 22 June 2015 (2015-06-22) See paragraphs [0026]-[0042]; and figures 1-4. | 1-17 |
| A | KR 10-2014-0095780 A (LG ELECTRONICS INC.) 04 August 2014 (2014-08-04) See entire document. | 1-17 |
| A | US 9037327 B2 (KIM, Sang Joon) 19 May 2015 (2015-05-19) See entire document. | 1-17 |

☐ Further documents are listed in the continuation of Box C.  ☑ See patent family annex.

| * | Special categories of cited documents: |
|---|---|
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **09 January 2024** | **10 January 2024** |

| Name and mailing address of the ISA/KR | Authorized officer |
|---|---|
| **Korean Intellectual Property Office** **Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

| INTERNATIONAL SEARCH REPORT Information on patent family members | | International application No. PCT/KR2023/014675 |
|---|---|---|

| Patent document cited in search report | | | Publication date (day/month/year) | Patent family member(s) | | | Publication date (day/month/year) |
|---|---|---|---|---|---|---|---|
| KR | 10-2021-0111128 | A | 10 September 2021 | None | | | |
| JP | 2020-029177 | A | 27 February 2020 | JP | 7174346 | B2 | 17 November 2022 |
| JP | 2015-116006 | A | 22 June 2015 | None | | | |
| KR | 10-2014-0095780 | A | 04 August 2014 | None | | | |
| US | 9037327 | B2 | 19 May 2015 | CN | 103419787 | A | 04 December 2013 |
| | | | | CN | 103419787 | B | 02 October 2018 |
| | | | | DE | 102012214962 | A1 | 21 November 2013 |
| | | | | DE | 102012214962 | B4 | 17 March 2022 |
| | | | | JP | 2013-243899 | A | 05 December 2013 |
| | | | | JP | 6009271 | B2 | 19 October 2016 |
| | | | | KR | 10-1956384 | B1 | 08 March 2019 |
| | | | | KR | 10-2013-0129738 | A | 29 November 2013 |
| | | | | US | 2013-0311016 | A1 | 21 November 2013 |

Form PCT/ISA/210 (patent family annex) (July 2022)

**EP 4 631 777 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020220183511
- KR 1020230114024